(19) Europäisches Patentamt

European Patent Office

Office européen des brevets

(11) Veröffentlichungsnummer: **0 315 170**
**A1**

(12) **EUROPÄISCHE PATENTANMELDUNG**

(21) Anmeldenummer: 88118323.0

(22) Anmeldetag: 03.11.88

(51) Int. Cl.4: **H01L 21/322** , **H01L 21/306** , **H01L 21/316**

(30) Priorität: 06.11.87 DE 3737815

(43) Veröffentlichungstag der Anmeldung:
**10.05.89 Patentblatt 89/19**

(84) Benannte Vertragsstaaten:
**DE FR GB**

(71) Anmelder: **Wacker-Chemitronic Gesellschaft für Elektronik-Grundstoffe mbH**
**Johannes-Hess-Strasse 24**
**D-8263 Burghausen(DE)**

(72) Erfinder: **Hahn, Peter, Dr. Dipl.-Phys.**
**Schopenhauer Weg 5**
**D-8263 Burghausen(DE)**
Erfinder: **Piontek, Hubert**
**Madlstrasse 2**
**D-8261 Burgkirchen(DE)**
Erfinder: **Schnegg, Anton, Dr. Dipl.-Chem.**
**Robert-Koch-Strasse 175**
**D-8263 Burghausen(DE)**
Erfinder: **Zulehner, Werner, Dr. Dipl.-Phys.**
**Karl-Gros-Strasse 1**
**D-8263 Burghausen(DE)**

(54) **Siliciumscheiben zur Erzeugung von Oxidschichten hoher Durchschlagsfestigkeit und Verfahren zu ihrer Herstellung.**

㉗ Es werden Siliciumscheiben und Verfahren zu ihrer Herstellung angegeben, die intrinsische Getterwirkung besitzen und auf denen sich dünne Oxidschichten mit hoher Durchschlagsfestigkeit erzeugen lassen. Erfindungsgemäß werden die Scheiben bei der Herstellung nach der Erzeugung der intrinsischen Getter im Scheibeninneren einer die Scheibenoberfläche glättenden Behandlung unterzogen, beispielsweise erneut poliert. Anschließend aufgebrachte Oxidschichten zeichnen sich durch eine gegenüber unbehandelten Scheiben erhöhte Durchschlagsfestigkeit aus.

EP 0 315 170 A1

## Siliciumscheiben zur Erzeugung von Oxidschichten hoher Durchschlagsfestigkeit und Verfahren zu ihrer Herstellung

Die Erfindung betrifft Siliciumscheiben zur Erzeugung von Oxidschichten hoher Durchschlagsfestigkeit und Verfahren zu ihrer Herstellung.

Mit zunehmender Miniaturisierung bei der Herstellung elektronischer Bauelemente steigen auch die Anforderungen an die als Ausgangsmaterial eingesetzten Siliciumscheiben. Zunehmend wichtig wird dabei die Eigenschaft, daß sie die Erzeugung von dünnen Oxidschichten hoher Durchschlagsfestigkeit gestatten. Der Hauptgrund dafur liegt darin, daß insbesondere in hochintegrierten Bauelementen als Strukturelemente in wachsendem Maße dünne Oxidschichten vorgesehen werden, von denen eine ausgezeichnete Durchschlagsfestigkeit gefordert wird.

Solche Oxidschichten werden in der Fachsprache häufig als "gate-oxide" bezeichnet. Sie werden in den meisten Fällen im Oberflächenbereich von Siliciumscheiben erzeugt, die im Scheibeninneren durch eine vorhergehende Behandlung gebildete, Getterwirkung aufweisende Bereiche besitzen, an die sich zumindest eine von solchen getternden Zentren freie und im allgemeinen bis zu etwa 50 $\mu$m dicke Oberflächenzone anschließt, in der bei der Bauelementeherstellung die eigentlich wirksamen Strukturen angelegt werden.

Ein Beispiel für eine Behandlung, mittels derer eine derartige Scheibencharakteristik erzeugt werden kann, ist die Präzipitation des in den Scheiben enthaltenen Sauerstoffes, welche insbesondere bei durch Tiegelziehen nach Czochralski erhaltenem Silicium angewendet wird. Bei diesem Material liegt der Sauerstoffgehalt typisch in Bereichen von $10^{14}$-$2 \times 10^{18}$ Atomen/cm$^3$. Dabei werden durch eine Temperaturbehandlung im Scheibeninneren Sauerstoffausscheidungen erzeugt (sog. "Präzipitate"), die wegen ihrer intrinsischen Getterwirkung große Bedeutung für die der eigentlichen Bauelementeherstellung dienenden Prozesse haben, welche in der von solchen Präzipitaten freien Randzone der Scheiben ("denuded zone") ablaufen. Diese Zusammenhänge und Verfahrensweisen sind bekannt und beispielsweise in dem Artikel "Advanced CZ crystal production for VLSI applications" von H. Walitzki und M. Blätte, erschienen in VLSI Science and Technology (1984), S.10-18, sowie der dort zitierten Literatur näher erläutert.

Neben der Bildung von Sauerstoffpräzipitaten haben andere bekannte Verfahren zur Erzeugung von intrinsischen Gettern in Siliciumscheiben, wie z.B. die gezielte Implantation von Fremdionen wie Wasserstoff oder Stickstoff, nur geringe Bedeutung und werden bisweilen z.B. bei sauerstoffarmem Material (typischer Sauerstoffgehalt $10^{12}$-$10^{16}$ Atome/cm$^3$), wie es beispielsweise durch tiegelfreies Zonenziehen erhalten wird, angewendet.

Unabhangig von der Methode, nach der die Bereiche mit intrinsischer Getterwirkung jeweils erzeugt werden, lassen sich jedoch bei den in üblicher Weise hergestellten und vorbehandelten Siliciumscheiben reproduzierbar und mit befriedigender Ausbeute die durchschnittlichen Durchschlagsfestigkeiten nur bis zu bestimmten Grenzwerten steigern. Die typischen Werte, bei denen bei den gängigen Siliciumqualitäten die Oxidschichten ihre Isolationsfähigkeit verlieren, schwanken dabei in Abhängigkeit von den jeweils eingesetzten Testverfahren. Solche Verfahren sind beispielsweise in Philips J. Res. 40, No. 3, 1985, erläutert.

Aufgabe der Erfindung war es daher, derartige Siliciumscheiben und Verfahren zu ihrer Herstellung anzugeben, die reproduzierbar und mit guter Ausbeute die Erzeugung von Oxidschichten mit einer demgegenüber erhöhten durchschnittlichen Durchschlagsfestigkeit gestatten.

Gelöst wird diese Aufgabe durch Siliciumscheiben, die dadurch erhältlich sind, daß vor der Erzeugung solcher Oxidschichten im Anschluß an eine die Bildung von Getterwirkung aufweisenden Bereichen im Scheibeninneren bewirkende Behandlung, ggf. nach Entfernung von dabei oberflächlich gebildeten Verbindungen, zumindest eine Scheibenoberfläche einer glättenden Behandlung unterzogen wird.

Der der glättenden Behandlung der Scheibenoberfläche vorgeschaltete Behandlungsschritt, bei dem im Scheibeninneren Bereiche mit Getterwirkung gebildet werden, kann in an sich bekannter Weise durchgeführt werden. Dies gilt insbesondere für Scheiben aus tiegelgezogenem Material, die im allgemeinen zur Bildung von Sauerstoffpräzipitaten als intrinsischen Gettern einem thermischen Behandlungszyklus unterzogen werden. Ein solcher Zyklus kann beispielsweise darin bestehen, daß die Scheiben, wie z.B.in der eingangs zitierten Literatur erläutert, für bestimmte Zeiträume auf Temperaturniveaus im Bereich zwischen 700 und 1200 $^\circ$C gebracht werden oder bestimmte Temperaturabläufe mit beispielsweise rampenartigem Profil durchlaufen. In diesem Zusammenhang sei auch auf den Artikel "Oxygen Precipitation and MOS Leakage after a Process Heat Simulation" von K. D. Beyer et al., J. Electrochem. Soc. Vol.134, No. 7, July 1987, p. 1753-1755, sowie die dort zitierte Literatur verwiesen, wo einige mögliche Temperaturschritte und -abläufe dargestellt sind, mit deren Hilfe sich in Siliciumscheiben Präzipitate mit intrinsischer Getterwirkung erzeugen lassen. Oftmals wird zu diesem Zweck auch ein Prozeß verwendet, bei dem nach einer ca. 4-8 -stündigen Behandlung der Scheiben bei ca. 1100-1200 °C in sauerstoffreier Atmosphäre und einer anschließenden ca. 4-16 -stündigen Behandlung bei ca. 700-800 °C diese schließlich noch für ca. 1-10 Stunden bei etwa 1000-1200 °C gehalten und dann dem Temperofen entnommen werden. Als Arbeitsatmosphäre haben sich bei diesen Schritten Sauerstoff oder sauerstoffhaltige Gasgemische bewährt.

Selbstverständlich sind neben dieser derzeit am häufigsten verwendeten Verfahrensweise auch andere, getternde Bereiche im Scheibeninneren erzeugende Prozesse nicht ausgeschlossen, wie z.B. die eingangs genannte Methode der Ionenimplantation von beispielsweise Wasserstoff oder Stickstoff.

Um eine wirkungsvolle glättende Behandlung der Scheibenoberfläche zu ermöglichen, werden vor diesem Schritt vorteilhaft die ggf. im Verlauf der vorgeschalteten Behandlungsschritte auf der Oberfläche gebildeten Reaktionsprodukte des Siliciums entfernt. Im Verlauf der Präzipitation bildet sich beispielsweise meist eine dünne Oxidschicht auf der Scheibenoberflache. Diese kann in der bekannten Art und Weise z.B. durch Abätzen mittels Flußsäure oder flußsäurehaltigen Mischungen entfernt werden. Im allgemeinen ist dafur ein kurzzeitiges Eintauchen der Scheiben in ein Ätzbad oder Besprühen mit Ätzlösung ausreichend.

Die eigentliche glättende Behandlung wird bevorzugt in Form eines Polierschrittes durchgeführt. Dabei wurde gefunden, daß nicht eine mit starkem Materialabtrag verbundene Politur, sondern ein hauptsächlich den Ausgleich von verbliebenen minimalen Unregelmäßigkeiten in der Scheibenoberfläche bewirkender Polierschritt für gute Ergebnisse wesentlich ist. Solche Schritte sind aus zahlreichen mehrstufigen Polierprozessen bekannt und werden dort typisch am Ende des Verfahrens als letzte Stufe eingesetzt, um auf der unter Materialabtrag polierten Scheibe eine einwandfrei schleierfreie Oberfläche zu erzeugen. Beispielhaft seien hier die Verfahren gemäß der DE-OS 22 47 067 bzw. der entsprechenden US-PS 38 74 129 oder auch gemäß der DE-OS 25 31 431 bzw. der entsprechenden US-PS 40 70 799 genannt. Dabei wird im letzten Schritt des Poliervorganges dem Poliermittel ein einwertiger Alkohol und Polyvinylalkohol bzw. ein anionenaktives und/oder nichtionogenes, keinen Stickstoff im Molekül enthaltendes Tensid zugesetzt, um die Oberfläche schleierfrei zu machen. Zusätzlich kann dazu noch der pH-Wert des Poliermittels bis in den Bereich von 3-8 erniedrigt werden, wobei auch siliciumorganische Verbindungen wie z.B. Trimethylsilanol als Zusatzstoffe in Frage kommen. Daneben kann auch beispielsweise die Erniedrigung des Polierdruckes und/oder der Einsatz spezieller Poliertücher zur Erzeugung einer schleierfreien Oberfläche bei geringem Polierabtrag beitragen.

Für die Durchführung des Polierschrittes im Rahmen des erfindungsgemäßen Verfahrens eignen sich die üblichen und dem Fachmann geläufigen Poliermaschinen. Vorteilhaft werden Zweiseitenpoliermaschinen eingesetzt, da bei ihnen die Scheiben nicht aufgekittet werden müssen und somit eine geringere Kontaminationsgefahr besteht. Hinzu kommt, daß die erhaltenen Scheiben, neben ihrer Getterwirkung sich durch besondere geometrische Präzision auszeichnen. Auf Einseitenpoliermaschinen wird man beispielsweise in den Fällen zuruckgreifen, in denen Halbleiterscheiben behandelt werden, deren Scheibenrückseite Getterwirkung besitzt, beispielsweise aufgrund einer in der Fachsprache häufig als "damage" bezeichneten mechanischen Behandlung, wie etwa durch Sandstrahlen, Eintauchen in ein Fluidbad oder durch gezieltes Verkratzen mittels in einem elastischen Trägermedium gebundener abrasiver Teilchen. Solche Methoden sind z.B. in der US-PS 45 87 771 bzw. der entsprechenden DE-OS 31 48 957 erläutert und dem Fachmann geläufig.

Der Polierabtrag wird allgemein so gering wie möglich gehalten; erfahrungsgemäß liegen die Obergrenzen bei Abträgen von bis zu 10 μm, vorzugsweise bis zu 3 μm, wobei oftmals schon Abträge von weniger als 1 μ ausreichend sind. Im Anschluß an die Polierbehandlung können die Scheiben dann, ggf. nach einem Reinigungsschritt, dem weiteren Bauelementeherstellungsprozeß zugeführt werden. Selbstverständlich muß die bei der Politur erzielte Oberflächenqualität den Erfordernissen dieser Prozesse gerecht werden. Dies kann beispielsweise durch stichprobenartige Kontrollen mit Hilfe der Methode gemäß ASTM - Standard F 1048 (1987) überwacht und sichergestellt werden, bei welcher mittels einer standardisierten Streulichtmessung die Qualität der Oberflächen beurteilt werden kann.

Neben dem Polieren kommen für die glättende Behandlung der Scheibenoberfläche auch andere Methoden in Frage, sofern sie eine für die nachfolgenden Prozesse ausreichende Oberflächenqualität gewährleisten. Denkbar ist beispielsweise ein kurzzeitiges Anschmelzen der Scheibenoberfläche durch Einwirkung von elektromagnetischer, vorzugsweise Lichtstrahlung, z.B. mittels Quecksilberdampflampen, wodurch sich Unebenheiten im Oberflächenprofil ausgleichen lassen. Gleichfalls denkbar ist der Einsatz von Ätzmischungen, die die Eigenschaft besitzen, Abweichungen der realen Scheibenoberfläche von der geometrisch idealen Oberfläche zu verringern. Beispiele für solche grundsätzlich bekannte Ätzmischungen sind sog. "Glanz-Ätzen", wie etwa saure Ätzen auf Basis von

HF/HNO$_3$ Mischungen im Verhältnis 9:1, die bei Raumtemperatur, oder alkalische Ätzen mit 25 Gew.-% KOH-Gehalt, die bei ca.80 °C eingesetzt werden.

Zweckmäßig schließt sich an die glättende Behandlung der Scheibenoberflache eine Reinigungsstufe an, in welcher etwa vorhandene Verunreinigungen mechanischer oder chemischer Art wie z.B. anhaftende Partikel oder störende Chemikalienreste entfernt werden, beispielsweise durch ein- oder mehrfaches Spülen mit hochreinem Wasser, ggf. in Kombination mit einer Ultraschallbehandlung. Geeignete Reinigungsprozesse sind bekannt und konnen beispielsweise analog der im Rahmen der Scheiben-Herstellung im Anschluß an den Polierprozeß durchgeführten Prozesse gestaltet werden. Die anschließend getrockneten Scheiben stehen dann für die Weiterverarbeitung zur Verfügung.

Überraschend wurde gefunden, daß sich auf nach dem beschriebenen Verfahren erhältlichen Siliciumscheiben dünne Oxidschichten erzeugen lassen, deren Durchschlagsfestigkeit gegenüber nicht in der erfindungsgemäßen Art und Weise behandelten, aber identisch vorbehandelten Scheiben deutlich erhöht ist. Dies verwundert um so mehr, als für die getternde Bereiche im Scheibeninneren erzeugende Behandlung als Ausgangsmaterial in beiden Fällen üblicherweise polierte Scheiben verwendet werden, d.h. Scheiben, deren Oberflächenqualität ohnehin höchsten Anforderungen entspricht. Aus diesen Gründen wird auch bei den bisher üblichen Prozessen, bei denen Gate-Oxidschichten auf intrinsisch getternden Siliciumscheiben erzeugt werden, streng darauf geachtet, daß die Scheibenoberfläche im Anschluß an den getternde Bereiche erzeugenden Teilschritt keinen irgendwie gearteten mechanischen Belastungen ausgesetzt ist.

Eine mögliche Erklärung für diese unerwartete Wirkung liegt darin, daß bei einem solchen Teilschritt eine geringfügige Aufrauhung der Scheibenoberfläche eintritt. Ein derartiger Effekt konnte inzwischen bei Scheiben aus tiegelgezogenem Silicium nach der durch einen thermischen Behandlungszyklus erfolgten Sauerstoff-Präzipitatbildung tatsächlich nachgewiesen werden. Als Meßmethode wurde dabei die äußerst empfindliche Laserabtastung und Streulichtmessung (gemäß der deutschen Patentanmeldung mit dem Aktenzeichen P 36 37 477.6) verwendet, deren Meßkurven eine geringfügige Erhöhung der Oberflächenrauhigkeit bei solcherart vorbehandelten Scheiben gegenüber der ursprünglichen polierten Oberfläche erkennen ließen.

Diese Eigenschaft kann auch zur Unterscheidung von nach dem erfindungsgemäßen Verfahren hergestellten Scheiben von den in gleicher Weise vorbehandelten, Sauerstoffpräzipitate als intrinsische Getterzentren enthaltenden konventionellen Scheiben, die keine glättende Nachbehandlung der Oberfläche erfahren haben, herangezogen werden.

Wegen der hohen Durchschlagsfestigkeit der aufgebrachten Oxidschichten lassen sich die nach dem erfindungsgemäßen Verfahren erhaltenen Siliciumscheiben mit besonderem Vorteil in solchen Prozessen als Substrate verwenden, in denen dieser Eigenschaft eine besondere Bedeutung zukommt. Beispiele dafür sind die Herstellung von Speicherelementen hoher Packungsdichte oder hochintegrierter Schaltkreise.

An Hand des nachstehenden Ausführungsbeispiels wird die Erfindung näher erläutert.

Ausführungsbeispiel:

Ein durch Tiegelziehen nach Czochralski erhaltener Siliciumstab (p-Dotierung, spez. Widerstand ca. 1-10 Ohm cm,(1 0 0)- Orientierung) wurde mittels Innenlochsäge in Scheiben zersägt; diese wurden anschließend in der üblichen Weise geläppt und mit Hilfe einer Zweiseitenpoliermaschine beidseitig schleierfrei poliert. Die Oberflächenqualitat der erhaltenen Scheiben wurde mit Hilfe der Methode der Laserabtastung und Streulichtmessung (gemäß der deutschen Patentanmeldung mit dem Aktenzeichen P 36 37 477.6) durch Vergleich mit einer einwandfrei schleierfrei polierten Referenzscheibe ermittelt und entsprach deren Güteklasse.

Entsprechend sechs verschiedenen Positionen entlang der Stablänge wurden nun jeweils paarweise Scheiben (Durchmesser ca. 10 cm, Dicke ca. 450 μ m) entnommen und zur Erzeugung von Sauerstoffpräzipitaten mit intrinsischer Getterwirkung einer Temperaturbehandlung unterworfen. Der Sauerstoffgehalt des Materials betrug laut Messung gemäß DIN 50438 bzw. der entsprechenden ASTM-Norm F 81 ca. $8.10^{17}$ Atome O/cm$^3$. Die Scheiben wurden in einem ersten Schritt in einem Temperofen fur ca. 6 Stunden auf einer Temperatur von ca. 1100 °C in einer Argonatmosphäre gehalten. Anschließend wurde die Temperatur auf ca. 750 °C erniedrigt und die Behandlung für ca. 6 Stunden unter Beimischung von ca. 10 Vol% trokkenem Sauerstoff zur Arbeitsatmosphäre fortgesetzt. Danach wurde die Temperatur auf ca. 1000 °C erhöht und unter Beibehaltung der trockenen oxidierenden Atmosphäre für weitere 6 Stunden auf die Scheiben einwirken gelassen. Damit war der Präzipitierungsschritt abgeschlossen und die Scheiben konnten entnommen werden. Abschließend wurde durch kurzzeitiges Eintauchen in ein ca. 6 Gew.-%-iges Flußsäurebad die auf der Scheibenoberfläche gebildete Oxidschicht abgeätzt.

Nun wurden die Scheibenpaare aufgeteilt.

Während 6 Scheiben unbehandelt blieben, wurden die anderen 6 Scheiben in einer handelsüblichen Zweiseitenpoliermaschine einem Polierschritt unterworfen. Als Poliermittel wurde dabei eine auf pH 7 eingestellte, ca. 5 Vol% Kieselsäuresol enthaltende Lösung eingesetzt, der zusätzlich etwa 0.5 Vol% Trimethylsilanol zugefügt waren.. Der Poliervorgang, eine zur Erzeugung einer schleierfreien Oberfläche bei geringem Abtrag geeignete Verfahrensvariante, dauerte etwa 5 Minuten; der dabei erzielte Abtrag betrug etwa 0.3 $\mu$ m. Eine anschließende Kontrollmessung der Oberflächenqualität ergab erneut die ursprüngliche Güteklasse, während bei den unbehandelten Scheiben eine zwar geringfügige, aber doch meßbare Erhöhung der Oberflächenrauhigkeit festzustellen war.

Nun wurden sowohl die glättend behandelten als auch die unbehandelten Scheiben einem Oxidationsschritt unterworfen. Zu diesem Zweck wurden beide Scheibengruppen in einem Oxidationsofen für ca. 15 Minuten auf etwa 1000 °C gehalten, wobei eine Argonatmosphäre mit ca. 10 Vol% trokkenem Sauerstoff vorlag. Dabei bildete sich auf den Scheibenoberflächen eine dünne Oxidschicht, wobei die Dickenwerte zwischen 283 und 294 Å variierten. Diese Werte wurden durch Messung mittels Ellipsometer ermittelt.

Die erhaltenen Scheiben wurden nun auf die Durchschlagsfestigkeit der auf ihrer Oberfläche erzeugten dünnen Oxidschichten überprüft. Als Meßmethode wurde ein Test angewendet, der grundsätzlich in D.R. Wolters, Growth, Conduction, Trapping and Breakdown of SiO$_2$ Layers on Silicon, Dissertation Groningen/Niederlande, 1985, beschrieben ist, und der es gestattet, die Qualität der Scheiben hinsichtlich der erzeugten Gate-Oxid-Schichten und damit die Eignung des Materials für aufwendige hochintegrierte Bauelemente abzuschätzen.

Zunächst wurden auf der Oxidschicht durch Bedampfen mit Aluminium MOS-Strukturen (Metal-Oxide-Semiconductor) erzeugt, deren Oberfläche etwa 0.0004 cm² betrug. Anschließend wurde die Scheibenrückseite metallisiert. Das Durchbruchsverhalten der Oxidschicht wurde dadurch ermittelt, daß an jeweils 70 dieser Elemente eine Spannung angelegt und, jeweils unter Messung der dabei auftretenden Stromstärke, kontinuierlich gesteigert wurde. Ein Element wurde jeweils dann als durchgebrochen angesehen, wenn der durchfließende Strom eine Stärke von 0,15 $\mu$ A erreicht hatte. Aus dem zugehörigen Wert für die Spannung wurde auch die entsprechende intrinsische Durchbruchsfeldstärke ermittelt, die den eigentlich aussagekräftigen Wert für die Gate-Oxid-Qualität darstellt, da sie um herstellungsbedingte vorzeitige Durchbrüche bereinigt und materialbezogen ist. Für die Auswertung wurde bei beiden Scheibengruppen jeweils die Prozentzahl der bei einer bestimmten Spannung durchgebrochenen Elemente gegenübergestellt. Bei den nicht polierten Scheiben waren bis zu einer Feldstärke von 8MV/cm nur etwa 4% der Elemente durchgebrochen. Danach setzte jedoch ein steiler Anstieg ein, und bei Feldstärken zwischen 8.8 und 9.0 MV/cm waren 98% der Elemente durchgebrochen. Bei der nach der Präzipitation erneut polierten Scheibengruppe setzte dieser steile Anstieg erst im Bereich zwischen 10.5 und 11.0 MV/cm ein, und erst bei 11.0 bis 11.4 MV/cm waren 98 % der Elemente durchgebrochen. Die erfindungsgemäß erhältlichen Siliciumscheiben zeichnen sich also durch eine gegenüber den herkömmlichen deutlich erhöhte intrinsische Durchbruchsfeldstärke aus.

## Ansprüche

1. Verfahren zur Herstellung von die Erzeugung von Oxidschichten hoher Durchschlagsfestigkeit gestattenden Siliciumscheiben, dadurch gekennzeichnet, daß vor der Erzeugung solcher Oxidschichten und im Anschluß an eine die Bildung von Getterwirkung aufweisenden Bereichen im Scheibeninneren bewirkende Behandlung, gegebenenfalls nach Entfernung von dabei oberflächlich gebildeten Verbindungen, zumindest eine Scheibenoberfläche einer. glättenden Behandlung unterzogen wird.

2. Verfahren nach Anspruch 1, dadurch gekennzeichnet, daß die glättende Behandlung ein Polierschritt ist.

3. Verfahren nach den Ansprüchen 1 oder 2, dadurch gekennzeichnet, daß die glättende Behandlung ein die Erzeugung einer schleierfreien Scheibenoberfläche bewirkender Polierschritt ist.

4. Verfahren nach den Ansprüchen 2 oder 3, dadurch gekennzeichnet, daß durch den Polierschritt eine bis zu 10 $\mu$ m dicke Oberflächenschicht abgetragen wird.

5. Verfahren nach Anspruch 1, dadurch gekennzeichnet, daß die glättende Behandlung durch Bestrahlung der Oberfläche mit elektromagnetischer Strahlung, insbesondere Lichtstrahlung, vorgenommen wird.

6. Verfahren nach Anspruch 1, dadurch gekennzeichnet, daß die glättende Behandlung durch Einwirkung von Ätzlösungen vorgenommen wird.

7. Verfahren nach einem oder mehreren der Ansprüche 1 bis 6, dadurch gekennzeichnet, daß als die Bildung von Getterwirkung aufweisenden Bereichen im Scheibeninneren bewirkende Behandlung eine die Bildung von Sauerstoffpräzipitaten bewirkende Temperaturbehandlung durchgeführt wird.

8. Siliciumscheiben zur Erzeugung von Oxidschichten hoher Durchschlagsfestigkeit, erhältlich nach einem Verfahren gemäß einem oder mehreren der Ansprüche 1 bis 8.

9. Siliciumscheiben nach Anspruch 8, gekennzeichnet durch eine der glättend behandelten Scheibenoberfläche gegenüberliegende Scheibenoberfläche mit Getterwirkung.

10. Siliciumscheiben nach Anspruch 8, gekennzeichnet durch einander gegenüber liegende glättend behandelte Scheibenoberflächen.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | EP-A-0 094 302 (FAIRCHILD CAMERA & INSTRUMENT CORP.) <br> * Seite 3, Zeile 27 - Seite 8, Zeile 8 * | 1-3,6-9 | H 01 L 21/322 <br> H 01 L 21/306 <br> H 01 L 21/316 |
| A | --- | 4 | |
| X | US-A-4 144 099 (IBM CORP.) <br> * Seite 2, Zeile 5 - Seite 4, Zeile 10 * | 1-4,8-10 | |
| X | PATENT ABSTRACTS OF JAPAN, Band 10, Nr. 168 (E-411)[2224], 14. Juni 1986; & JP-A-61 020 337 (NIPPON DENKI K.K.) 29-01-1986 <br> * Zusammenfassung; Figuren * | 1,7-9 | |
| A | US-A-4 231 809 (BELL TELEPHONE LABORATORIES INC.) <br> * Seite 3, Zeile 27 - Seite 4, Zeile 16 * | 1,6-9 | |
| | --- | | RECHERCHIERTE SACHGEBIETE (Int. Cl.4) |
| A | US-A-4 390 392 (TEXAS INSTRUMENTS INC.) <br> * Figuren 3,4; Zusammenfassung; Seite 2, Zeilen 51-56 * | 1,5 | H 01 L |

Der vorliegende Recherchenbericht wurde für alle Patentansprüche erstellt

| Recherchenort | Abschlußdatum der Recherche | Prüfer |
|---|---|---|
| DEN HAAG | 16-01-1989 | GELEBART J.F.M. |